# EUROPEAN PATENT SPECIFICATION

(11) **EP 2 066 031 B1**
(45) Date of publication and mention of the grant of the patent: **05.10.2016**
(21) Application number: 08020303.7
(22) Date of filing: 21.11.2008
(51) Int. Cl.: H03J 1/00

(54) **Terminal and method of controlling broadcast signals in a mobile terminal**
Endgerät und Verfahren zur Steuerung von Rundfunksignalen in einem mobilen Endgerät
Terminal et procédé de contrôle des signaux de diffusion dans un terminal mobile

(30) Priority: 30.11.2007 KR 20070123225
(43) Date of publication of application: 03.06.2009
(73) Proprietor: LG Electronics Inc., Seoul 150-010 (KR)
(72) Inventor: Kim, Tae Jung, Kumchon-gu Seoul,153-801 (KR); Yang, Sung Chul, Kumchon-gu Seoul,153-801 (KR)
(74) Representative: Katérle, Axel

(56) References cited:
- EP-A- 1 657 946
- EP-A- 1 659 711
- US-A1- 2003 032 400
- US-A1- 2005 024 264
- US-A1- 2005 289 592
- US-A1- 2006 253 875
- TAMOSOFT: 'CommView for WiFi v5.6', [Online] 27 November 2007, Retrieved from the Internet: <URL:http://web.archive.org/web/20071127064 411/http://www.fileheap.com/software-commvi ew-for-wifi-download-23138.html> [retrieved on 2011-08-26]

## Description

### BACKGROUND OF THE INVENTION

### Field of the Invention

The present invention relates to a terminal and method of supporting broadcast signals.

### Discussion of the Related Art

A terminal is a device which may be configured to perform various functions. Examples of such functions include data and voice communications, capturing images and video via a camera, recording audio, playing music files via a speaker system, and displaying images and video on a display.

Some terminals include additional functionality which supports game playing, while other terminals are configured as multimedia players. More recently, terminals have been configured to receive broadcast and multicast signals which permit viewing of content such as videos and television programs.

Supported broadcast signals are hard-coded to a terminal in the manufacturing process. The terminal receives and outputs an audio/video signal for at least one channel provided by the hard-coded broadcast signal.

For example, document US 2003/0032400 A1 describes a dynamically programmable frequency scanning radio receiver and a method for programming the same. The radio receiver identifies the location of the radio receiver, searches in a frequency database for transmitting parties in the identified location, and monitors the frequencies corresponding to the specific transmitting party. Therefore, when the radio receiver is moved to a geographical area wherein the transmitting parties of interest have different frequencies, the radio receiver may be dynamically reprogrammed based upon the new location.

Documents US 2006/253875 A1 and US 2005/289592 A1 describe mobile terminals for receiving multiple broadcasting techniques and methods for managing channel information.

Related art terminals do not provide a method for supporting a plurality of broadcast signals. Additionally, there is no method for supporting a broadcast signal suitable for a corresponding region by distinguishing different broadcast signals from each other if a different broadcast signal is supported in a region.

### SUMMERY OF THE INVENTION

Features and advantages of the invention will be set forth in the description which follows, and in part will be apparent from the description, or may be learned by practice of the invention. The objectives and other advantages of the invention will be realized and attained by the structure particularly pointed out in the written description and claims hereof as well as the appended drawings.

In accordance with an embodiment, the current invention provides a mobile terminal. The mobile terminal comprises a user input unit; a wireless communication unit configured to recognize a location of the mobile terminal and comprising a broadcast receiving module, the broadcast receiving module is configured to receive a plurality of broadcast signals associated with multiple broadcasting technologies recognized at a location and scan channel frequencies for the plurality of broadcast signals associated with multiple broadcast technologies; a controller configured to process a scan result received from the wireless communication unit, to obtain channel information for each broadcast signal from the scan result and to control the display of the obtained channel information; and an output unit configured to display the channel information for each broadcast signal under the control of the controller, the plurality of broadcast signals associated with multiple broadcasting technologies include valid region information, and when the mobile terminal recognizes that it has changed regions, the mobile terminal is configured to receive broadcast signal information for valid broadcast signals in the new recognized location.

In one feature the wireless communication unit recognizes a location of the mobile terminal and scans the channel frequencies for the at least one broadcast signal available at the recognized location. Additionally, the wireless communication unit receives broadcast signal information related to the at least one broadcast signal available at the recognized location and scans the channel frequencies for the at least one broadcast signal. Furthermore, the wireless communication unit scans the channel frequencies for the at least one broadcast signal and stores the channel information for the at least one broadcast signal in a memory.

In another feature, the mobile terminal also includes a user input unit for receiving a selection of the at least one broadcast signal, wherein the wireless communication unit scans the channel frequencies for the selected at least one broadcast signal under control of the controller.

In yet another feature, the wireless communication unit receives broadcast relevant information and the output unit displays channel information matched to the received broadcast relevant information under control of the controller. Additionally, the controller controls the output unit to display a recommended channel among at least one or more channels provided by the at least one broadcast signal.

In still yet another feature, the mobile terminal further includes a user input unit for receiving a selection of a channel among at least one or more channels provided by the at least one broadcast signal using the displayed channel information, wherein the output unit outputs a signal provided from the selected channel under control of the controller.

In another feature, the output unit outputs a plurality of signals provided from a plurality of selected channels under control of the controller if the user selects a plurality of channels provided by the at least one broadcast signal. Additionally, if the output unit outputs a new signal provided from the selected channel the user selects a channel among at least one or more channels provided by the broadcast signal that is different from the currently selected channel. Finally, the controller switches the selected channel to an alternative channel among the at least one or more channels provided by the at least one broadcast signal and the output unit outputs a new signal provided from the alternative channel if a broadcast reception quality is less than predetermined reference value.

In accordance with another embodiment, a method of supporting broadcast signals in a mobile terminal is provided. The method comprises scanning channel frequencies for a plurality of broadcast signals associated with different broadcasting technologies; processing a scan result; obtaining channel information for each broadcast signal from the scan result; and displaying the obtained channel information for each broadcast signal.

These and other embodiments will also become readily apparent to those skilled in the art from the following detailed description of the embodiments having reference to the attached figures, the invention not being limited to any particular embodiment disclosed.

### BRIEF DESCRIPTION OF THE DRAWING

The above and other aspects, features, and advantages of the present invention will become more apparent upon consideration of the following description of preferred embodiments, taken in conjunction with the accompanying drawing figures, wherein;
Fig. 1 is a block diagram of a terminal in accordance with an embodiment of the present invention.
Fig. 2 is a perspective view of a front side of a terminal according to an embodiment of the present invention.
Fig. 3 is a rear view of the terminal illustrated in Fig. 2.
Fig. 4 is a block diagram of a CDMA wireless communication system operable with a terminal of the present invention.
FIG. 5 is a flowchart for a method of receiving a broadcast signal in a terminal according to one embodiment of the present invention.
FIG. 6 is a flowchart for a method of receiving a broadcast signal related to a location in a terminal according to one embodiment of the present invention.
FIGS. 7A to 7C are diagrams of screens illustrating a process for scanning a plurality of broadcast signals in a terminal according to one embodiment of the present invention.
FIGS. 8A to 8D are diagrams of screens illustrating a process for scanning a plurality of broadcast signals available for a current location in a terminal according to one embodiment of the present invention.
FIGS. 9A to 9F are diagrams of screens illustrating a process for displaying channel information for each of a plurality of broadcast signals in a terminal according to one embodiment of the present invention.
FIG. 10A and FIG. 10B are diagrams of screens illustrating a process for outputting a broadcast signal provided from a channel selected using channel information in a terminal according to one embodiment of the present invention.
FIGS. 11A to 11C are diagrams of screens illustrating a process for selecting a channel related to a broadcast signal while a different channel is output in a terminal according to one embodiment of the present invention.
FIG. 12A and FIG. 12B are diagrams of screens illustrating a process for switching to an alternative channel while a channel is output in a terminal according to one embodiment of the present invention.

### DETAILED DESCRIPTION OF THE PREFERRED EMBODIMENTS

In the following detailed description, reference is made to the accompanying drawing figures which form a part hereof, and which show by way of illustration specific embodiments of the invention. It is to be understood by those of ordinary skill in this technological field that other embodiments may be utilized, and structural, electrical, as well as procedural changes may be made without departing from the scope of the present invention. Wherever possible, the same reference numbers will be used throughout the drawings to refer to the same or similar parts.

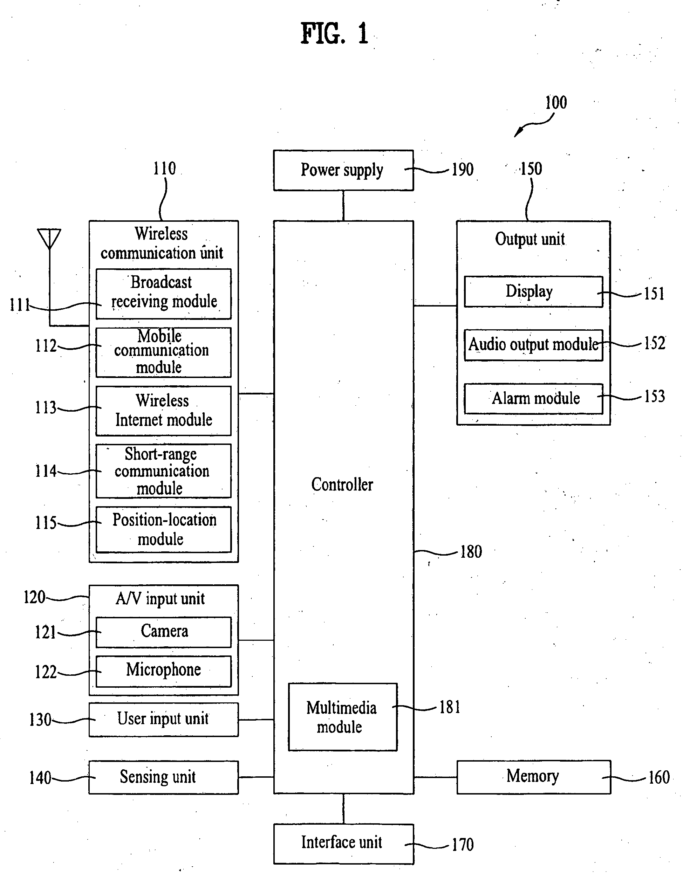

Fig. 1 is a block diagram of terminal 100 in accordance with an embodiment of the present invention. The terminal 100 may be implemented as a variety of terminal types. Examples of such terminals include mobile phones, user equipment, smart phones, computers, digital broadcast terminals, personal digital assistants, portable multimedia players (PMP), and navigators.

By way of non-limiting example only and for convenience and conciseness of the following description, the present invention is illustrated as a mobile phone. It is not intended to limit the scope of the present invention. The teachings of the present invention apply equally to other types of terminals.

Fig. 1 shows the terminal 100 having various components, but it is understood that implementing all of the illustrated components is not a requirement. Greater or fewer components may alternatively be implemented.

Fig. 1 shows the terminal 100 having a wireless communication unit 110 configured with various components. The broadcast receiving module 111 receives a broadcast signal and broadcast associated information from an external broadcast managing entity via a broadcast channel.

The broadcast channel may include a satellite channel or a terrestrial channel. The broadcast managing entity may be a system which transmits a broadcast signal or broadcast associated information.

Examples of broadcast associated information include information associated with a broadcast channel, a broadcast program, or a broadcast service provider. For example, broadcast associated information may include an electronic program guide (EPG) of digital multimedia broadcasting (DMB) or electronic service guide (ESG) of digital video broadcast-handheld (DVB-H).

The broadcast signal may be implemented as a TV broadcast signal, a radio broadcast signal, or a data broadcast signal. The broadcast signal may further include a broadcast signal combined with a TV or radio broadcast signal.

The broadcast receiving module 111 may receive broadcast signals transmitted from various types of broadcast systems. By nonlimiting example, such broadcasting systems include digital multimedia broadcasting-terrestrial (DMB-T), digital multimedia broadcasting-satellite (DMB-S), digital video broadcast-handheld (DVB-H), the data broadcasting system known as media forward link only (MediaFLO^{®}), and integrated services digital broadcast-terrestrial (ISDB-T).

The broadcast receiving module may also receive multicast signals. Data received by the broadcast receiving module 111 may be stored in a suitable device, such as memory 160

The mobile communication module 112 transmits and receives wireless signals to and from one or more network entities, such as a base station or a Node-B. The wireless signals may represent audio, video, multimedia, control signaling, or data.

The wireless internet module 113 provides Internet access for the terminal. The wireless internet module 113 may be internally or externally coupled to the terminal 100.

The short-range communication module 114 facilitates short-range communications. Suitable technologies for implementing this module include radio frequency identification (RFID), infrared data association (IrDA), ultra-wideband (UWB), as well at the networking technologies commonly referred to as Bluetooth™ and ZigBee™.

The position-location module 115 identifies and obtains the location of the terminal 100. The position-location module 115 may be implemented using global positioning system (GPS) components which cooperate with associated satellites and network components.

The audio/video (A/V) input unit 120 provides audio or video signal input to the terminal 100. The A/V input unit 120 may include a camera 121 and a microphone 122. The camera receives and processes image frames of still pictures or video.

The microphone 122 receives an external audio signal while the portable device is in a particular mode, such as a phone call mode, a recording mode, or a voice recognition mode. The audio signal is processed and converted into digital data. The terminal 100 and A/V input unit 120 may include assorted noise removing algorithms to remove noise generated in the course of receiving the external audio signal.

Data generated by the A/V input unit 120 may be stored in the memory 160, utilized by the output unit 150, or transmitted via one or more modules of communication unit 110. The terminal 100 may include two or more microphones and cameras.

The user input unit 130 generates input data in response to user manipulation of an associated input device or devices. Examples of such devices include a keypad, a dome switch, a touchpad, a jog wheel, and a jog switch.

The sensing unit 140 provides status measurements for various aspects of the terminal 100. For example, the sensing unit may detect an open and closed state of the terminal 100, relative positioning of components of the terminal, a change of position of the terminal, a change of position of a component of the terminal, a presence or absence of user contact with the terminal, orientation of the terminal, or acceleration or deceleration of the terminal. The sensing unit 140 may also sense the presence or absence of power provided by the power supply 190 and the presence or absence of a connection between the interface unit 170 and an external device.

The interface unit 170 may be implemented to connect the terminal with an external device. External devices include wired or wireless headphones, external chargers, power supplies, storage devices configured to store data, or microphones. The interface unit 170 may be configured using a wired and wireless data port, audio input/output (I/O) ports, or video (I/O) ports. The interface unit 170 may also include a card socket for connecting various cards, such as a memory card, a subscriber identity module (SIM) card, a user identity module (UIM) card, or a replaceable user identity module (RUIM) card.

The output unit 150 outputs information associated with the terminal 100. The display 151 is typically implemented to display information associated with the terminal 100. For example, the display 151 may provide a graphical user interface which includes information associated with a phone call if the terminal is operating in a phone call mode. The display 151 may display images which are associated with various modes, such as a video call mode or a photographing mode.

The display 151 may be configured as a touch screen working in cooperation with the input unit 130, in one embodiment of the present invention. This configuration allows the display 151 to function both as an output device and an input device.

The display 151 may be implemented using known display technologies such as a liquid crystal display (LCD), a thin film transistor-liquid crystal display (TFT-LCD), an organic light-emitting diode display (OLED), a flexible display, or a three-dimensional display. The terminal 100 may include one or more of such displays. An example of a two-display embodiment is one in which one display 151 is configured as an internal display which is viewable when the terminal is in an opened position and a second display 151 configured as an external display which is viewable in both the open and closed positions.

Fig. 1 further shows the output unit 150 having an audio output module 152. The audio output module 152 may be implemented using one or more speakers, buzzers, or other audio producing devices.

The audio output module 152 functions in various modes including a call-receiving mode, a call-placing mode, a recording mode, a voice recognition mode, or a broadcast reception mode. The audio output module 152 outputs audio related to a particular function, such as a call notification, a message notification, or a error notification.

The output unit 150 is further illustrated having an alarm module 153, which may be used to identify the occurrence of an event associated with the terminal 100. An example of such output includes providing a vibration as a notification to a user.

The alarm module 153 may vibrate when the terminal 100 receives a call or message. Vibration may also be provided by the alarm module 153 in response to receiving user input at the terminal 100, thereby providing a tactile feedback mechanism. It is understood that the various outputs provided by the components of output unit 150 may be performed separately or performed using any combination of the components.

The memory 160 may be implemented using any type of volatile and non-volatile memory or storage devices. Such devices may include random access memory (RAM), static random access memory (SRAM), electrically erasable programmable read-only memory (EEPROM), erasable programmable read-only memory (EPROM), programmable read-only memory (PROM), read-only memory (ROM), magnetic memory, flash memory, magnetic or optical disk, card-type memory, or other similar memory or data storage device.

The controller 180 controls the overall operations of the terminal. For example, the controller 180 performs the control and processing associated with voice calls, data communications, video calls, camera operations, and recording operations.

The controller may include a multimedia module 181 which provides multimedia playback. The multimedia module 181 may be configured as part of the controller 180 or may be implemented as a separate component.

The power supply 190 provides power to the various components of the terminal 100. The power provided may be internal power or external power.

In the following description, operation between the respective components of the terminal 100 according to the present invention are explained in detail with reference to FIG. 1.

The wireless communication unit 110 periodically or randomly scans channel frequencies for a plurality of broadcast signals in response to a users command signal input.

The controller 180 receives the results of a channel frequency scan from the wireless communication unit 110 and then outputs a control signal to the output unit 150 for displaying channel information obtained from the scan results. The output unit 150 receives the control signal from the controller 150 and displays the channel information obtained from the scan results.

The wireless communication unit 110 determines the location of the terminal 100 using the position-location module 115. The controller 180 then controls the wireless communication unit 110 to scan channel frequencies for broadcast signals available at the current location of the terminal 100.

The wireless communication unit 110 may receive information related to the broadcast signals available at the location and may store information related to the available broadcast signals in the memory 160. The controller 180 receives a broadcast signal from the selected channel via the broadcast receiving module 111 and outputs the received broadcast signal via the output unit 150 when a specific channel has been selected from the displayed channel information.

Various embodiments described herein may be implemented in a computer-readable medium using computer software. The various embodiments may also be implemented in hardware.

A hardware implementation may be implemented using one or more application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, or other electronic units designed to perform the functions described herein. Some embodiments are implemented by controller 180.

A software implementation of the embodiments described herein may be implemented with separate software modules, such as procedures and functions, each of which perform one or more of the functions and operations described herein. The software code may be implemented with a software application written in any suitable programming language and may be stored in the memory 160 for execution by the controller 180 or a processor.

The terminal 100 may be implemented in a variety of different configurations. Examples of such configurations include folder-type, slide-type, bar-type, rotational-type, and swing-type.

For clarity, further disclosure will primarily relate to a slide-type terminal 100. However such teachings apply equally to other types of terminals 100.

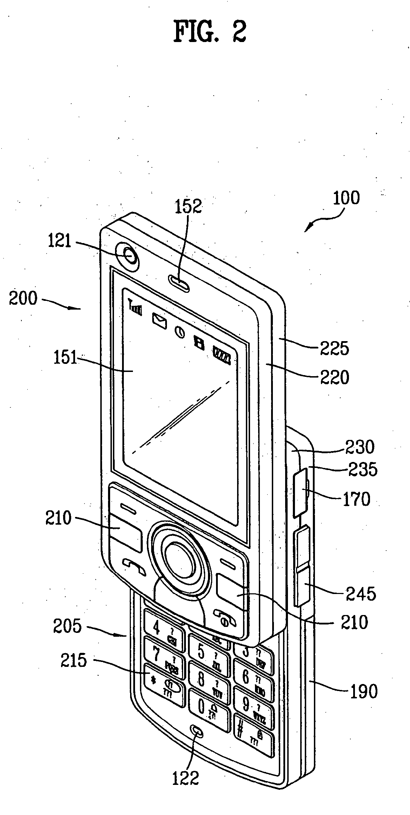

Fig. 2A is a perspective view of a front side of a terminal 100 according to an embodiment of the present invention. As illustrated in Fig. 2A, the terminal 100 is illustrated having a first body 200 configured to slideably cooperate with a second body 205.

The first body 200 slides relative to second body 205 between open and closed positions. The first body 200 is positioned over the second body 205 in the closed position such that the keypad 215 is substantially or completely obscured by the first body. The user may access the keypad 215, the display 151, and function keys 210 in the open position. The function keys 210 may be configured for a user to enter commands such as 'start', 'stop', or 'scroll'.

The user input unit 130 is implemented using the function keys 210 and keypad 215. The function keys 210 are associated with the first body 200 and the keypad 215 is associated with the second body 205. The keypad 215 includes various keys such as numbers, characters, and symbols, to enable a user to place a call, prepare a text or multimedia message, and operate the terminal.

The terminal 100 is operable in either a standby mode or an active call mode. Typically, the terminal 100 functions in the standby mode when in the closed position and in the active mode when in the open position. The mode configuration may be changed as required or desired by the user.

The first body 200 is illustrated formed from a first case 220 and a second case 225 and the second body 205 is illustrated formed from a first case 230 and a second case 235. The respective first and second cases may be formed from a suitably ridge material such, as injection molded plastic, or formed using metallic material, such as stainless steel (STS) and titanium (Ti).

One or more intermediate cases may be provided between the first case 220 and second case 225 of the first body 200 or between the first case 230 and second case 235 the second body 205. The first body 200 and the second body 205 may be sized to house electronic components necessary to support operation of the terminal 100.

The first body 200 is illustrated having a camera 121 and audio output module 152. The camera 121 may be selectively positioned such that camera may rotate or swivel relative to the first body 200.

The function keys 210 are positioned adjacent to a lower side of the display 151. The display 151 is illustrated implemented as an LCD. The display 151 may also be configured as a touchscreen having an underlying touchpad which generates signals responsive to user contact with the touchscreen.

The second body 205 is illustrated having a microphone 122 positioned adjacent to the keypad 215 and side keys 245 positioned along the side. The side keys 245 may be configured as hot keys, such that the side keys are associated with a particular function of the terminal 100.

An interface unit 170 is illustrated positioned adjacent to the side keys 245. A power supply 190 in a form of a battery is located on a lower portion of the second body 205.

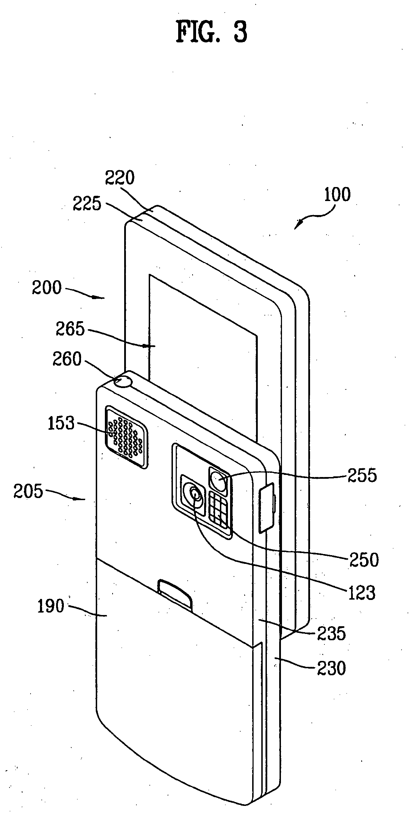

Fig. 3 is a rear view of the terminal 100 illustrated in FIG. 2. As illustrated in Fig. 3, the second body 205 includes a camera 123, a flash 250, and a mirror 255.

The flash 250 operates in conjunction with the camera 123. The mirror 255 is useful for assisting a user to position the camera 123 in a self-portrait mode.

The camera 123 of the second body 205 faces a direction opposite to a direction faced by camera 121 of the first body 200. The camera 121 of the first body 200 and camera 123 of the second body 205 may have the same or different capabilities.

In one embodiment, the camera 121 of the first body 200 operates with a relatively lower resolution than the camera 123 of the second body 205. Such an arrangement works well during a video conference in which reverse link bandwidth capabilities may be limited. The relatively higher resolution of the camera 123 of the second body 205 is useful for obtaining higher quality pictures.

The second body 205 also includes an audio output module 153 configured as a speaker which is located on an upper side of the second body. The audio output module 152 of the first body 200 and the audio output module 153 of second body 205 may cooperate to provide stereo output. Moreover, either or both of the audio output modules 152 and 153 may be configured to operate as a speakerphone.

A broadcast signal receiving antenna 260 is illustrated located at an upper end of the second body 205. The antenna 260 functions in cooperation with the broadcast receiving module 111. The antenna 260 may be fixed or configured to retract into the second body 205.

The rear side of the first body 200 includes a slide module 265. The slide module 265 slideably couples with a corresponding slide module (not illustrated) located on the front side of the second body 205.

It is understood that the illustrated arrangement of the various components of the first body 200 and the second body 205 may be modified as desired. Some or all of the components of one body may alternatively be implemented on the other body. In addition, the location and relative positioning of the components are not critical to many embodiments and, therefore, the components may be positioned at locations which differ from those illustrated by the representative figures.

The terminal 100 may operate in a communication system capable of transmitting data via frames or packets. The communication system may include wired communication, wireless communication, or a satellite-based communication system.

The communication system may utilize various systems such as frequency division multiple access (FDMA), time division multiple access (TDMA), code division multiple access (CDMA), universal mobile telecommunications system (UMTS), long term evolution (LTE) of the UMTS, or the global system for mobile communications (GSM). By way of non-limiting example, further description will relate to a CDMA communication system, but such teachings apply equally to other system types.

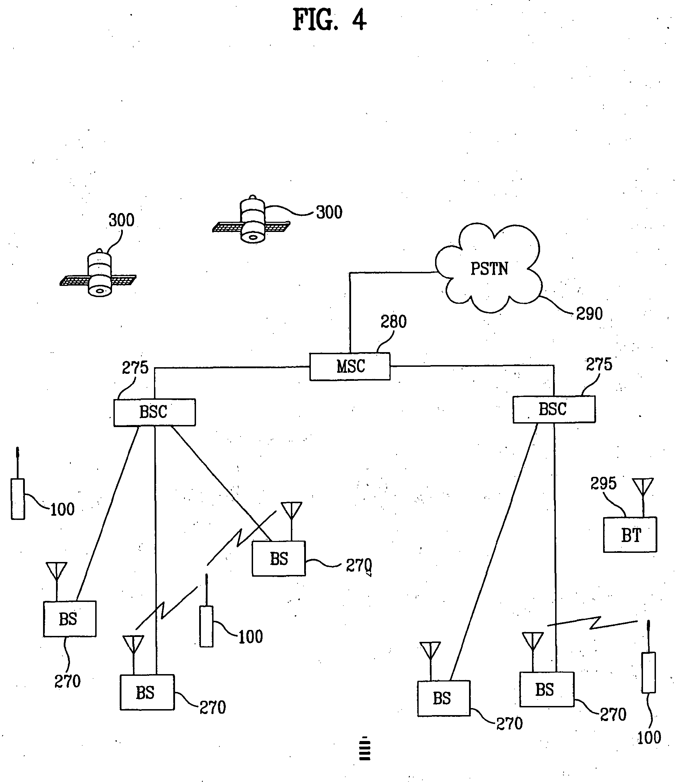

As illustrated in Fig. 4, a CDMA wireless communication system is illustrated having a plurality of terminals 100, a plurality of base stations (BS) 270, base station controllers (BSC) 275, and a mobile switching center (MSC) 280. The MSC 280 is configured to interface with a conventional public switch telephone network (PSTN) 290 and is also configured to interface with the BSCs 275.

The BSCs 275 are coupled to the BSs 270 via backhaul lines. The backhaul lines may be configured in accordance with any of several known interfaces including E1/T1, ATM, IP, PPP, Frame Relay, HDSL, ADSL, or xDSL. It is to be understood that the system may include more than two BSCs 275.

Each BS 270 may include one or more sectors, each sector having an omnidirectional antenna or an antenna pointed in a particular direction radially away from the BS 270. Each sector may include two antennas for diversity reception. Each BS 270 may be configured to support a plurality of frequency assignments, with each frequency assignment having a particular spectrum.

The intersection of a sector and frequency assignment may be referred to as a CDMA channel. The BSs 270 may also be referred to as base station transceiver subsystems (BTSs). In an alternate embodiment, the term "base station" may be used to refer collectively to a BSC 275 and one or more BSs 270.

The BSs 270 may also be denoted "cell sites." Alternatively, individual sectors of a given BS 270 may be referred to as cell sites

A broadcasting transmitter (BT) 295 is illustrated broadcasting to terminals 100 operating within the system. The broadcast receiving module 111 of the terminal 100 is configured to receive broadcast signals transmitted by the BT 295. Similar arrangements may be implemented for other types of broadcast and multicast signaling.

Fig. 4 also shows several global positioning system (GPS) satellites 300. The GPS satellites 300 facilitate locating the position of some or all of the terminals 100. The position-location module 115 of the terminal 100 is typically configured to cooperate with the satellites 300 to obtain position information.

Other types of position detection technology may be used in addition to or instead of GPS location technology. Some or all of the GPS satellites 300 may alternatively or additionally be configured to provide satellite DMB transmissions.

The BSs 270 receive sets of reverse-link signals from various terminals 100 during operation of the wireless communication system. The terminals 100 are performing calls, messaging, or other communications.

Each reverse-link signal received by a BS 270 is processed within that BS. The resulting data is forwarded to an associated BSC 275. The BSC 275 provides call resource allocation and mobility management functionality including soft handoffs between base stations 270. The BSCs 275 also route the received data to the MSC 280, which provides additional routing services for interfacing with the PSTN 290. Similarly, the PSTN 290 interfaces with the MSC 280 and the MSC interfaces with the BSC 275, which in turn control the BSs 270 to transmit sets of forward-link signals to the terminals 100.

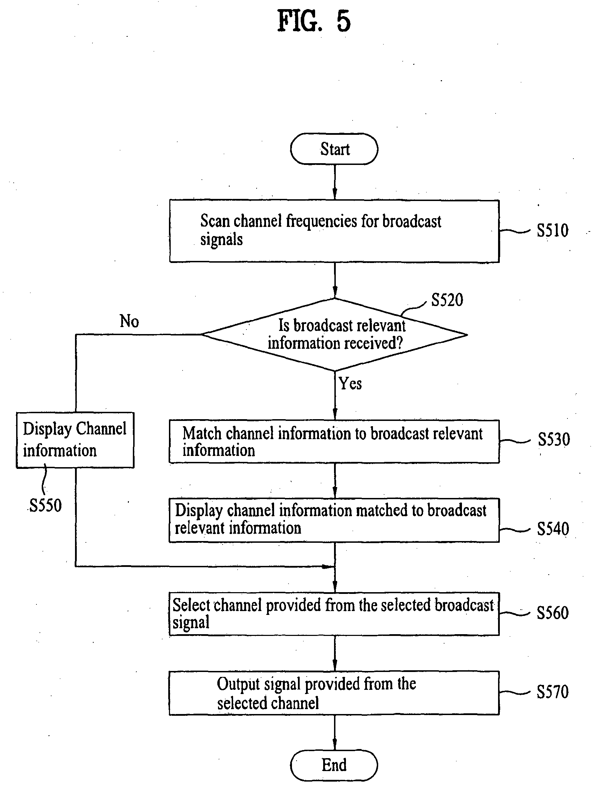

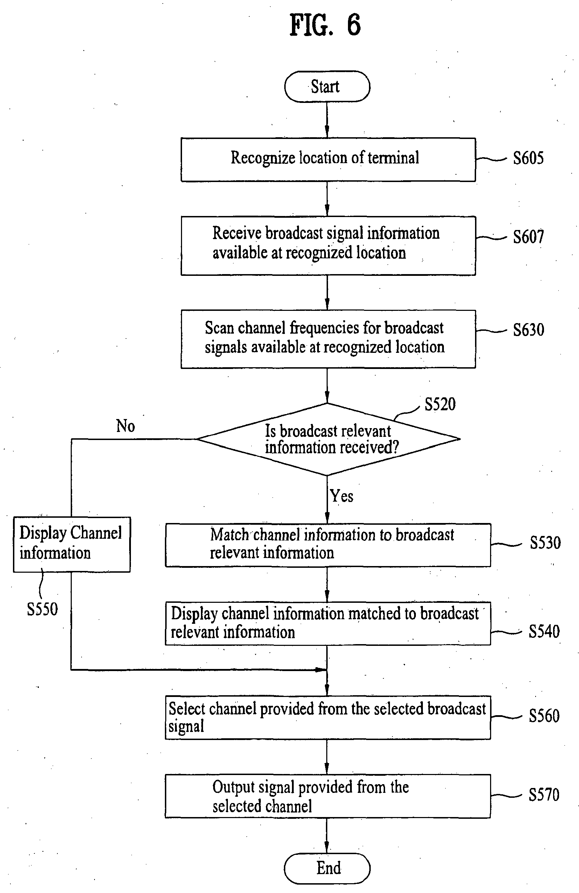

A broadcast signal reception method of a terminal according to the present invention is explained with reference to FIG. 5 and FIG. 6. FIG. 5 is a flowchart for a first broadcast signal reception method according to one embodiment of the present invention. FIG. 6 is a flowchart for a second broadcast signal reception method according to another embodiment of the present invention.

Broadcast signals refer to signals that support broadcast transceiving operations including broadcast signals and broadcast relevant data. For example, the broadcast signals may include DVB-T (Digital Video Broadcasting-Terrestrial), DVB-H (Digital Video Broadcasting-Handheld), DMB (Digital Multimedia Broadcasting), MediaFLO (Media Forward Link Only), ISDB-T (Integrated Services Digital Broadcast-Terrestrial), or MBMS (Multimedia Broadcast Multicast Service).

The channel frequency refers to a frequency band allocated to at least one channel provided by the broadcast signal. Different channel frequencies may be set for a plurality of broadcast signals.

The terminal 100 scans channel frequencies for broadcast signals via the wireless communication unit 110 (S510). The broadcast receiving module 111 included in the wireless communication unit 110 receives a scan execution command signal from the controller 180 and executes the scan of channel frequencies (S510).

The terminal 100 may include a separate component (not illustrated) to execute the scan (S510). Scanning for channel frequencies may be performed based on a periodic schedule or may be performed randomly.

For example, if the terminal 100 enters a broadcast mode, a user may input a scan command signal by selecting a channel scanning function via the user input unit 130. A user may also input a scan command signal by selecting a scan command signal input key provided by the user input unit 130.

When scanning the channel frequencies, the terminal 100 may scan a channel frequency for at least one broadcast signal selected from a plurality of the broadcast signals by a user. The terminal 100 stores information received from the broadcast signal in the memory 160.

The information received from the broadcast signal includes available region information, channel frequency, or broadcast signal identification information. Therefore, a user may select a broadcast signal and the terminal 100 may retrieve the channel frequency assigned to the selected broadcast signal from the memory 160.

A difference between the first and second methods, as illustrated in FIG. 6, is that the terminal 100 may recognize its current location using the position-location module 115 (S605) and thus receives broadcast signal information available at the recognized location (s607).

For example, the terminal 100 may recognize its current location (s605) using information received from a satellite in the GPS system or position information of a network or base station of a current location. The terminal 100 receives information on broadcast signals available at the recognized location obtained via the position-location module via the wireless communication unit 110 (S607).

The information obtained from the broadcast signals may include available region information, channel frequency information, broadcast signal identification information, or channel information. It is assumed that the broadcast signals may differ according to a region.

When the terminal 100 recognizes that it has changed regions the terminal may receive broadcast signal information for the available broadcast signals in the new recognized location (S620). The terminal 100 stores the broadcast signal information of the available broadcast signal supported by the recognized location in the memory 160.

When a terminal 100 enters a region, the terminal may check the memory 160 to determine whether the current location is stored in the region information. The terminal 100 may also periodically or randomly receive information on all broadcast signals regardless of the current location of the terminal 100 (S607).

Broadcast signal information may be received (s607) if the terminal 100 determines that the broadcast signal information stored in the memory 160 needs to be updated. For example, the broadcast signal information may be received (s607) when the terminal 100 enters a region for which no broadcast signal information is stored in the memory 160, when a region supports a new broadcast signal which is not stored in the memory 160, when the stored broadcast signal information is changed, or when a user selects the reception of broadcast signal information. The terminal 100 scans channel frequencies for the available broadcast signals for the recognized location (S630).

The step of receiving broadcast signal information (s607) may be omitted if the terminal 100 enters a previously visited location, since the terminal has previously stored broadcast signal information supported by the location or region. The method illustrated in Fig. 5 is the same as the method illustrated in Fig. 6 in this case.

The terminal 100 then determines whether broadcast relevant information is received via the wireless communication unit 110 (S520).

The broadcast relevant information refers to channel information, broadcast organization information according to channel, broadcast program information, or available region information, provided by a broadcast signal. The broadcast relevant information may be periodically or randomly received.

The broadcast relevant information may relate to broadcast signals available for a location or region. In this case, the broadcast relevant information may be received upon entering a specific location or region.

The terminal 100 matches the received broadcast relevant information to the channel information (S530). The channel information may be the information for at least one channel provided by the corresponding broadcast signal and may include an available/unavailable or unified channel list, assigned frequency according to channel, or channel identification information, such as a channel name or a channel ID.

Matching channel information to broadcast related information (s530) may be performed in response to a user request. No matching (S530) may be performed despite the existence of received broadcast relevant information if a matching command is not input by a user.

The terminal 100 displays the channel information matched to the broadcast relevant information via the display 151 (S540). The terminal 100 displays channel information for each of a plurality of the broadcast signals according to the scan of channel frequencies result if the broadcast relevant information is not received (S550).

The terminal 100 may display channel information for a plurality of the broadcast signals or individual information for one of a plurality of the broadcast signals when displaying channel information (s540, s550).

The terminal 100 may display sorted channel information corresponding to a sorting condition selected by a user. The sorting condition may include a channel genre, a broadcast time zone, a presence or non-presence of pay/free channel, a viewing age, or an audience rating.

A channel provided by one of the plurality of broadcast signals is selected from the displayed channel information (S560). The terminal 100 may then output an audio/video signal provided from the selected channel (S570).

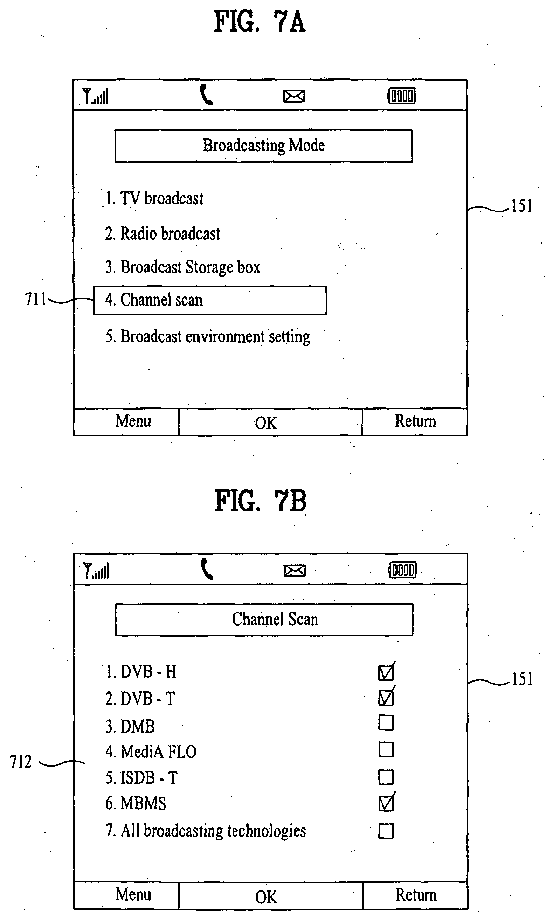

The scanning of channel frequencies (S510) is explained in detail with reference to FIGS. 7A through 7C. FIGS. 7A through 7C illustrate a process for scanning a plurality of broadcast signals in a terminal 100 according to one embodiment of the present invention.

For clarity and convenience of description, the scan process is illustrated as implemented in a standby mode. However, the scan process may be implemented while executing an application associated with the terminal 100, such as a broadcast output or a multimedia play.

As illustrated in FIG. 7A, the terminal 100 enters a broadcasting mode and displays a list of functions that may be executed in the broadcasting mode. As illustrated in FIG. 7B, the terminal 100 displays a channel scan list 712 with broadcast signals if 'Channel Scan' 711 is selected from the list illustrated in FIG. 7A.

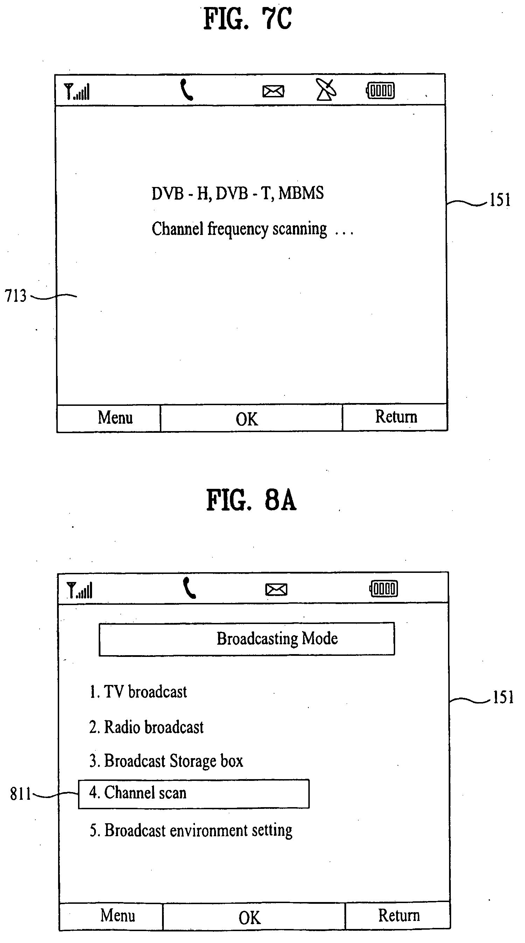

The user then selects at least one broadcast signal to scan from the channel scan list 712. As illustrated in FIG. 7C, the terminal 100 scans channel frequencies for the selected broadcast signals and indicates that a scanning process is in progress if at least one broadcast signal, such as DVB-H, DVB-T, or MBMS, is selected from the channel scan list 712.

The scanning of channel frequencies of the recognized location (S630) is explained in detail with reference to FIGS. 8A through 8D. FIGS. 8A through 8D illustrate screens of a process for scanning a plurality of broadcast signals available for a current location of a terminal according to a second embodiment of the present invention. For clarity and convenience of description, the scan process is illustrated as implemented in a standby mode. However, the scan process may be implemented in the course of executing an application associated with the terminal 100, such as a broadcast output or a multimedia play.

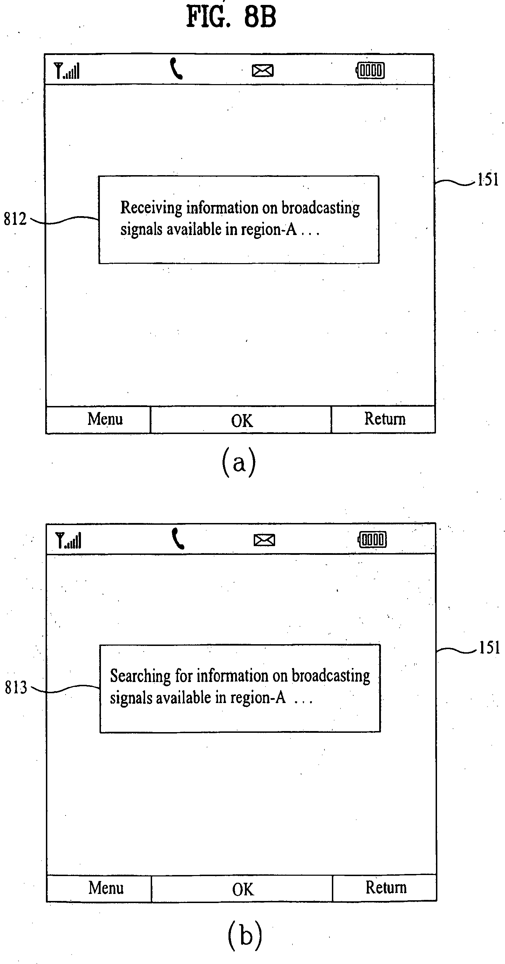

As illustrated in FIG. 8A, the terminal 100 displays a list indicating functions that may be executed when the terminal 100 has entered a broadcasting mode. If 'channel scan' 811 is selected from the list, the terminal 100 receives broadcast signal information available for the current location 'region-A' and indicates that reception is in progress, as illustrated in FIG. 8B(a). The terminal 100 may automatically receive information related broadcast signals available for 'region-A' if the terminal 100 determines that it has entered 'region-A' regardless of whether 'channel scan' 811 was selected by a user.

If the channel scan 811 is selected from the list, the terminal 100 searches the memory 160 for the broadcast signal information available for the current location 'region-A' as illustrated in FIG. 8B(b). The memory 160 stores all supported broadcast signals by classifying the information based on an available region.

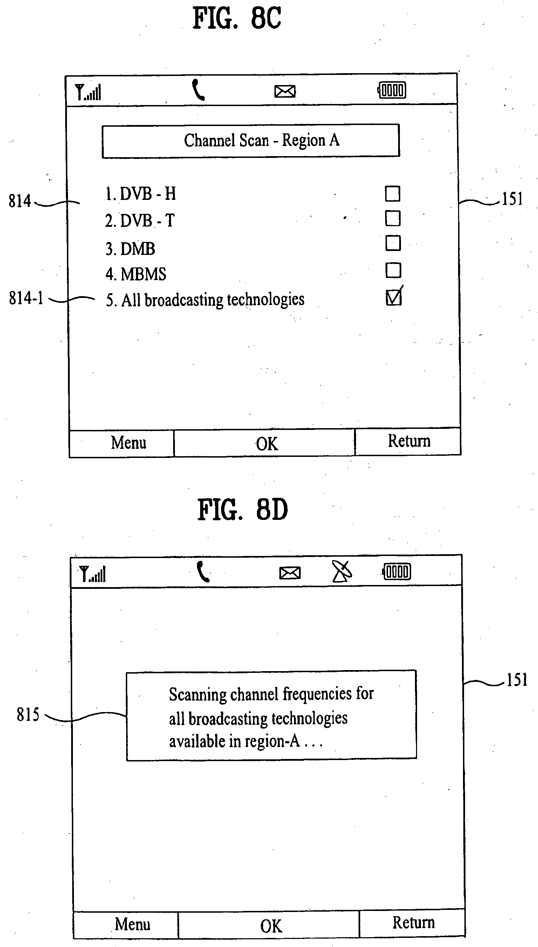

The terminal 100 displays a list 814 indicating the broadcast signals available for the 'region-A', as illustrated in FIG. 8C. The user selects a specific broadcast signal to scan from the list.

The list is constructed from the broadcast signal information received from the channel scan illustrated in FIG. 8B(a) and the broadcast signal information received from the memory as illustrated in FIG. 8B(b). If 'All broadcasting technologies' 814-1 is selected from the list, the terminal 100 scans all channel frequencies for all the broadcasting technologies available for the 'region-A' and indicates that scan is in progress, as illustrated in FIG. 8D. The terminal 100 may scan all channel frequencies for all broadcasting technologies available for the 'region-A' without a broadcast signal selection made by a user if 'channel scan' 811 is selected in FIG. 8A.

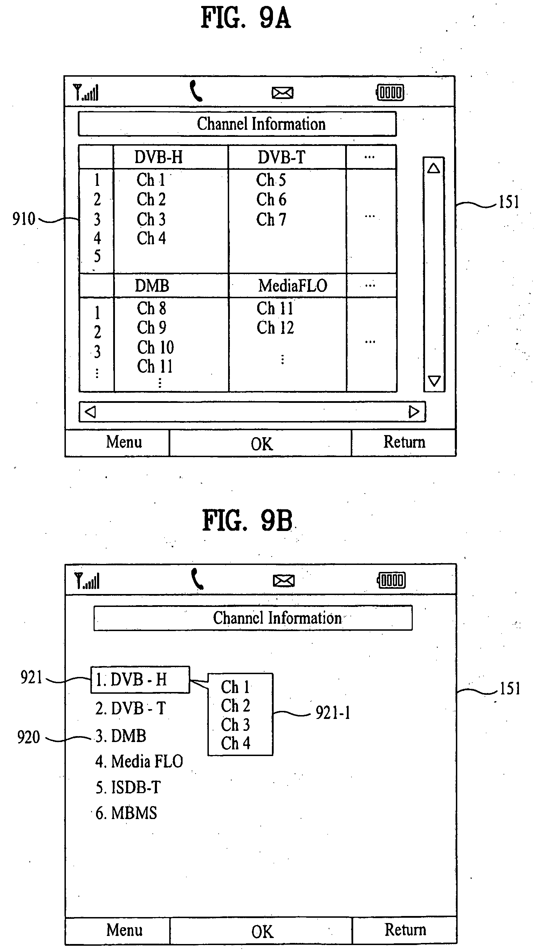

Steps S540 and S550 are explained in detail with reference to FIGS. 9A to 9F. FIGS. 9A to 9F illustrate screens a process for displaying channel information for each of a plurality of broadcast signals in a terminal 100 according to of the present invention.

As illustrated in FIG. 9A, the terminal 100 may display a channel list 910 including channel names from every supported broadcast signal. A user may then select a specific channel to view from the channel list.

Referring to FIG. 9B, the terminal 100 displays a broadcast signal list 920 indicating all supported broadcast signals. If a specific broadcast signal 921 is selected, the terminal 100 displays a list 921-1 including channels offered by the selected broadcast signal. The list 921-1 may be displayed using a popup window system, a partitioned screen system, an image switching system, or a word-balloon system, as illustrated in FIG. 9B.

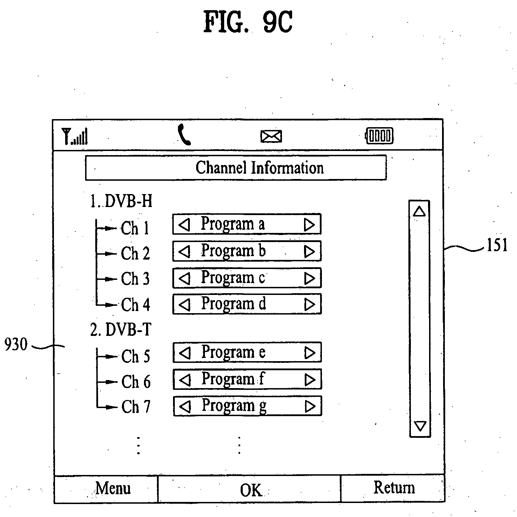

As illustrated in FIG. 9C, the terminal 100 displays a broadcast signal list 930 constructed with supported broadcast signals and may provide a currently broadcasted program title, a previous program title, or a next program title for a channel on a channel list when displaying the channel information matched to the broadcast relevant information. The channel list includes channels provided by each of the supported broadcast signals. Therefore, a user may obtain information on programs offered on a channel.

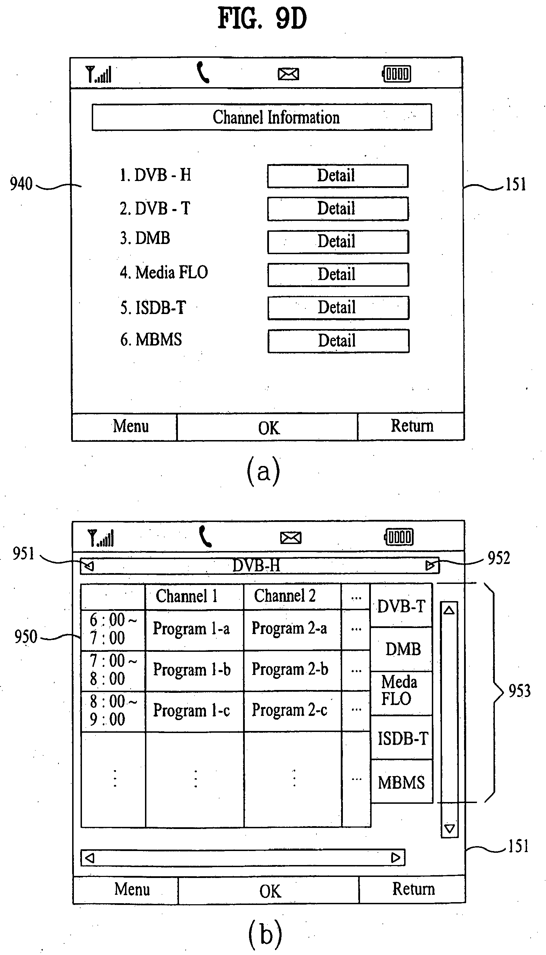

As illustrated in FIG. 9D, the terminal 100 displays a broadcast signal list 940 including supported broadcast signals. The terminal 100 also displays a broadcast signal name and 'detail' as a field in order to facilitate selection of a provision of broadcast relevant information for a corresponding broadcast signal as illustrated in FIG. 9D(A).

As illustrated in FIG. 9D(a), the terminal displays broadcast organization information on channels provided by 'DVB-H' if 'Detail' displayed together with 'DVB-H' is selected, as illustrated in FIG. 9D(b). As illustrated in FIG. 9D(b), the terminal 100 is provided with a broadcast technology list in an index format 953 or direction keys 951 and 952 on an upper end of a corresponding image to enable a user to select other broadcast signals.

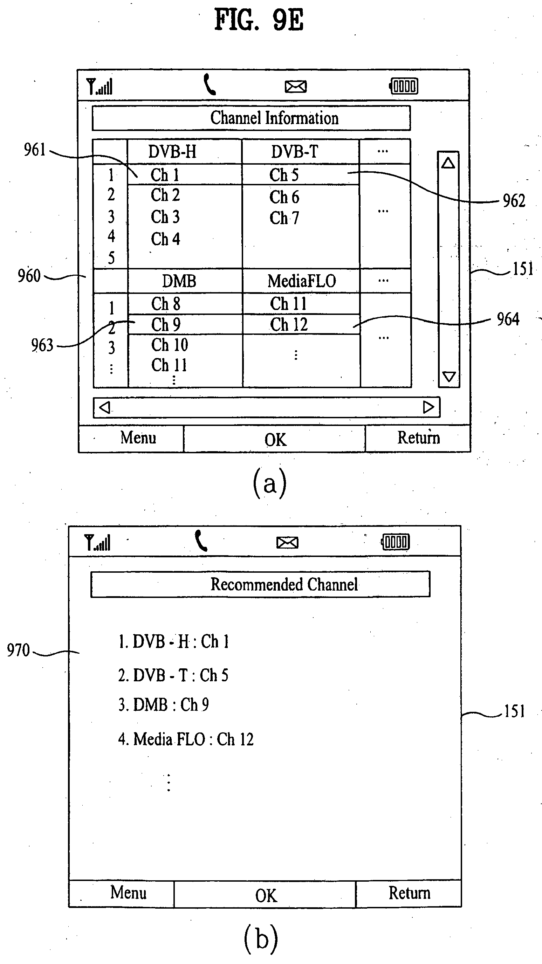

As illustrated in FIG. 9E, the terminal 100 may display channel information indicating a recommended channel among at least one or more channels provided by each of the supported broadcast signals. The recommended channel refers to a channel that is recommended to a user and may be selected with reference to a broadcast receptibility, a data transceiving rate, a data transceiving size, or a data quality.

For example, as illustrated in FIG. 9E(a), the terminal 100 recommends 'Ch 1' 961, 'Ch 5' 962, 'Ch 9' 963, and 'Ch 12' 964 among the channels provided for a broadcast signal on a channel information list 960. As illustrated in FIG. 9E(b), the terminal 100 may display a recommended channel list 970 constructed with recommended channels from broadcast signals if a 'recommend' area is selected in FIG. 9E(a).

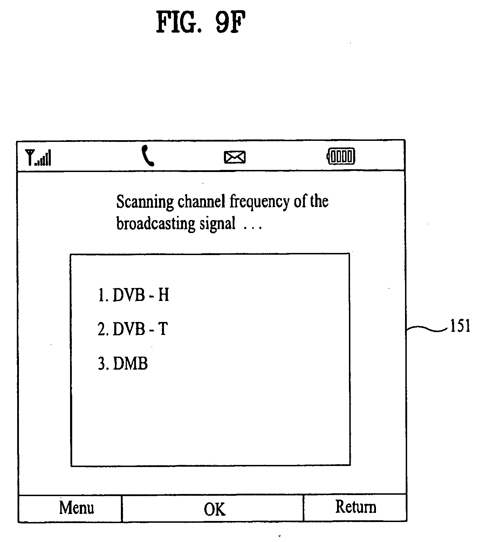

As illustrated in FIG. 9F, the terminal 100 may display a broadcast signal information list having a real-time scanning result displayed while scanning a channel frequency for broadcast signals. The terminal 100 may display the channel information provided by the selected broadcast signal information if a specific broadcast signal information is selected (not illustrated).

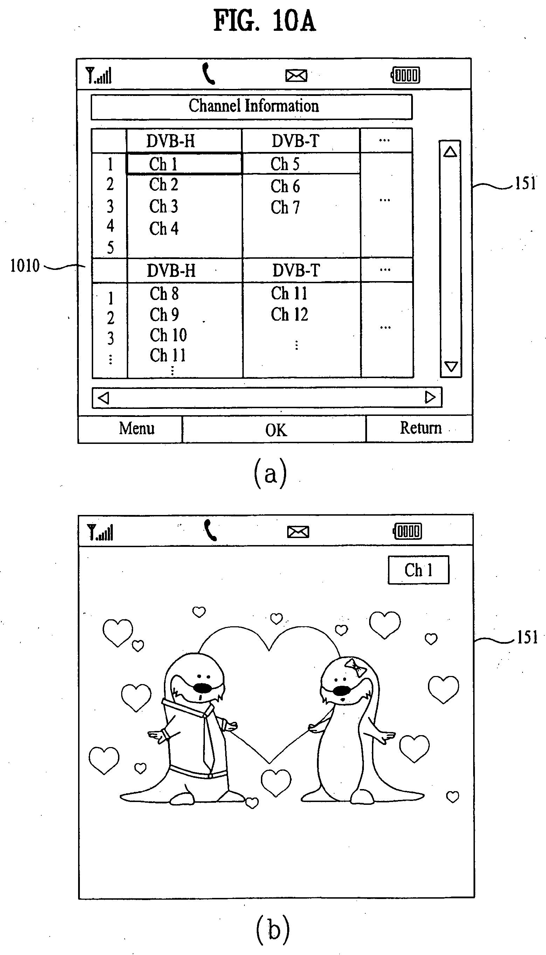

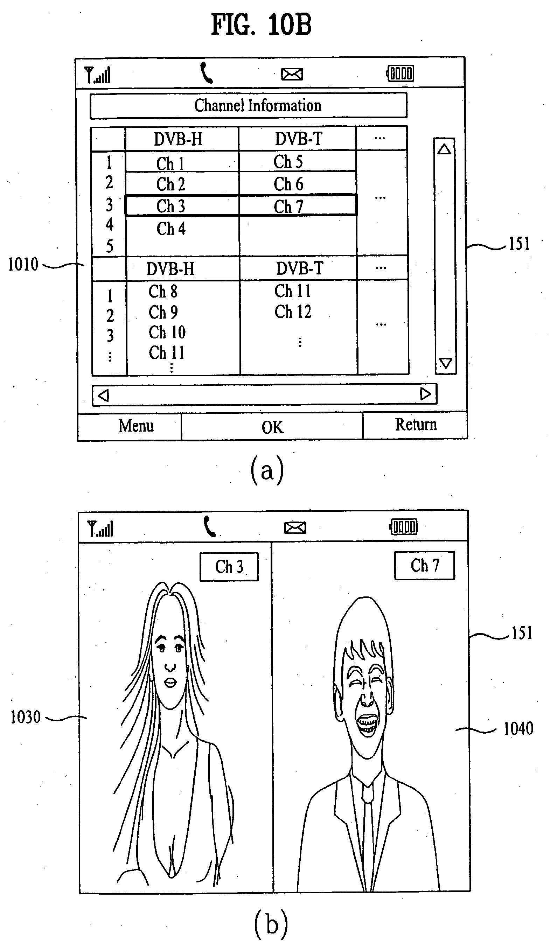

Step S560 and the step S570 are explained in detail with reference to FIGS. 10A and 10B. FIGS. 10A and 10B illustrate screens of a process for outputting a broadcast signal provided from a selected channel using channel information in a terminal 100 according to the present invention.

As illustrated in FIG. 10A, the terminal 100 outputs an audio/video signal provided from the 'Ch 1' via the output unit 150 if 'Ch 1' is selected from a 'channel list 1010, as illustrated in FIG. 10A(b). A video signal is output via the display 151 and an audio signal is output via the audio output module 152.

As illustrated in FIG. 10B, the terminal 100 may output audio/video signals provided from a plurality of the selected channels. For example, the terminal 100 may simultaneously output video signals provided from 'Ch 3' and 'Ch 7' if 'Ch 3' and 'Ch 7' are selected from the channel list 1010 in FIG. 10B(a).

When a broadcast signal is output as a video signal, a screen may be divided into a plurality of areas, with a video signal of 'Ch 3' output to a first area 1030 and a video signal of 'Ch 7' 1013 is output to a second area 1040. An audio signal output may be configured to output an audio signal of either 'Ch 3' or 'Ch 7' in accordance with a selection made by a user.

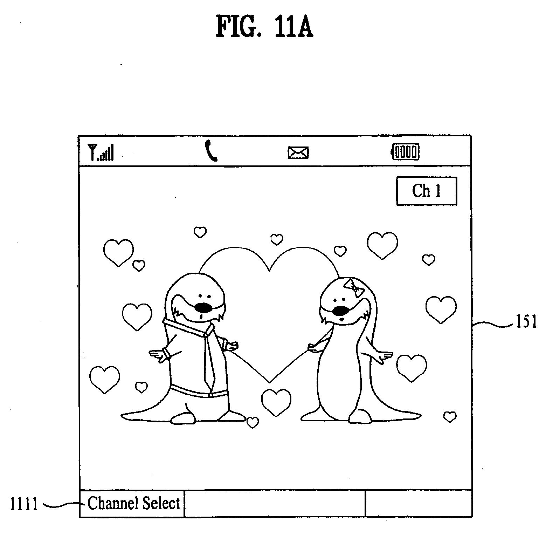

Output of an audio/video signal is explained in detail with reference to FIGS. 11A through 11C. FIGS. 11A through 11C illustrate screens of a process for selecting a channel of a broadcast signal that is different from the current audio/video output in a terminal 100 according to one embodiment of the present invention.

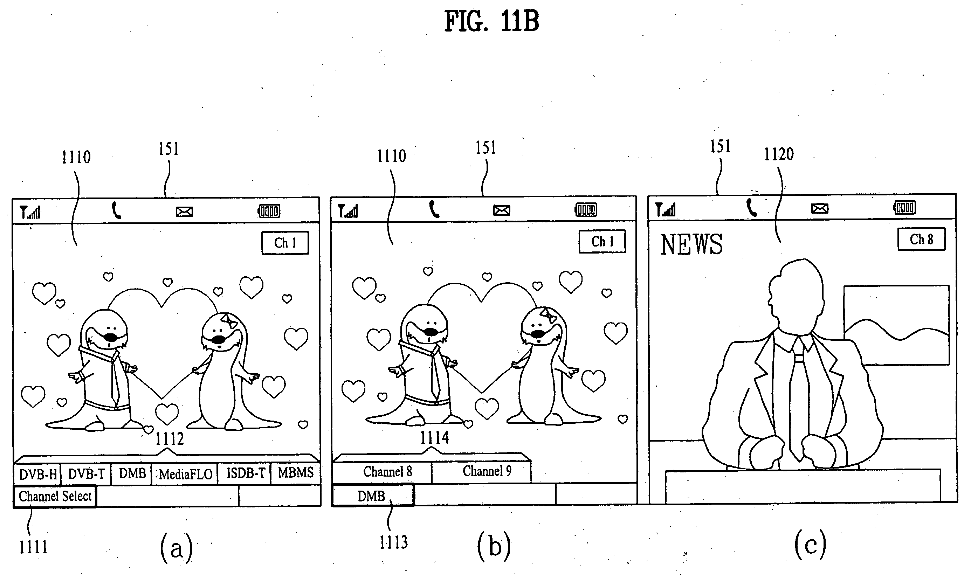

As illustrated in FIG. 11A, the terminal 100 outputs a audio/video signal received from a channel provided by a first broadcast signal. As illustrated in FIG. 11B(a), the terminal 100 displays a list of supported broadcast signals 1112 while maintaining the output of the audio/video signal of FIG. 11A if 'Channel Select' 1111 is selected by a user in FIG. 11A. As illustrated in FIG. 11B(b), the terminal 100 displays a list of channels provided by the 'DMB' while maintaining the output of the audio/video signal of FIG. 11A if broadcast signal 'DMB' that is different from the first broadcast signal is selected from the list 1112 by a user in FIG. 11B(a). The terminal 100 stops the audio/video output of FIG. 11A and outputs a audio/video signal provided from 'Channel 8', as illustrated in FIG. 11B(c), if 'Channel 8' is selected by a user in FIG. 11B(b).

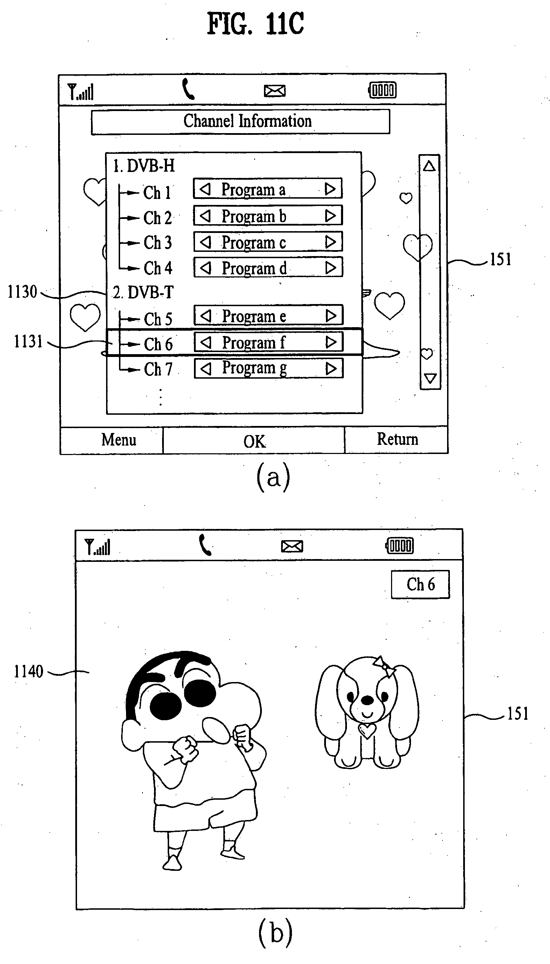

As illustrated in FIG. 11C(a), the terminal 100 displays a list 1130 of supported broadcast signals and an associated channel list while maintaining the output of the audio/video signal of FIG. 11A if 'Channel Select' 1111 is selected by a user in FIG. 11A. The terminal 100 stops the output of the audio/video signal of FIG. 11A and outputs a audio/video signal provided from 'Ch 6', as illustrated in FIG. 11C(b), if 'Ch 6' is selected in FIG. 11C(a).

The terminal 100 switches a current channel to output an alternative channel provided by the broadcast signals if a reception quality of the current channel that is being output is less than a predetermined reference. The alternative channel is the channel that provides a broadcast signal similar to or identical to the current channel.

The alternative channel provides a user with a broadcast of the same or similar contents if broadcast reception of a current channel is poor. The predetermined condition may include a broadcast receptibility, a data rate, a data transmission size, or a data quality.

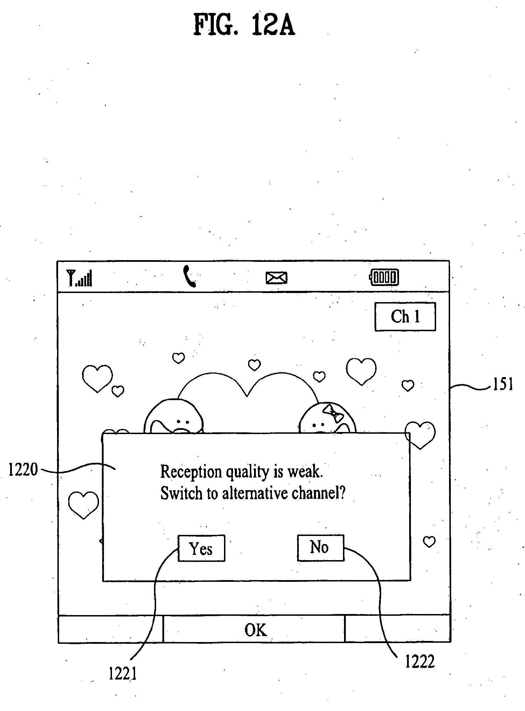

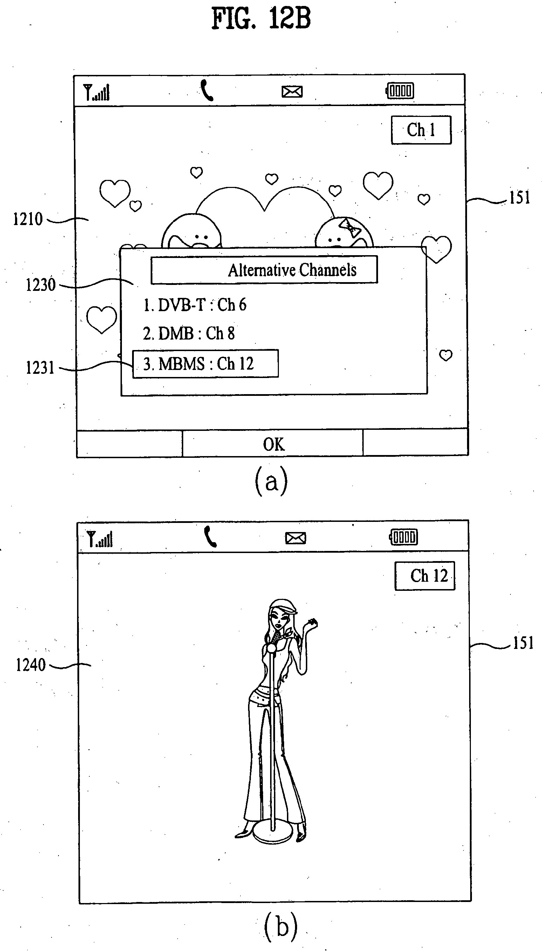

Switching to the alternative channel may be executed by a user or may be randomly executed by the terminal 100. The process of switching to an alternate channel will be explained in detail with reference to FIGS. 12A and 12B. FIGS. 12A and 12B illustrate a process for switching to an alternative channel during the output of a broadcast signal in a terminal 100 according to one embodiment of the present invention.

As illustrated in FIG. 12A, the terminal 100 may determine that the reception quality of a broadcast signal is less than a predetermined reference value. The terminal 100 may display a window 1220 which allows a user to switch to an alternative channel.

If the user switches to the alternative channel by selecting 'yes' 1221, the terminal 100 displays an alternative channel list 1230 including a plurality of alternative channels provided by a plurality of broadcast signals, as illustrated in FIG. 12B(a). As illustrated in FIG. 12B(b), the terminal 100 may output a broadcast signal provided from the alternative channel 'Ch 12' if 'MBMS: Channel 12' is selected from the alternative channel list 1230 in FIG. 12B(a).

The broadcast signal method according to the present invention may be implemented with computer-readable codes on a medium having a program recorded thereon. The computer-readable recording media include all kinds of storage devices for storing data that can be read by computer systems, such as ROM, RAM, CD-ROM, magnetic tapes, floppy discs, and optical data storage devices as well as a device implemented with carrier waves, such as transmission via the Internet. The computer may include the controller 180 of the terminal 100.

The present invention provides various effects or advantages. First, the present invention provides a terminal capable of supporting a plurality of broadcast signals. Second, the present invention displays channel information for a plurality of broadcast signals in a terminal that supports a plurality of the broadcast signals.

## Claims

1. A mobile terminal (100) comprising:
a user input unit (130); and
a wireless communication unit (110) configured to recognize a location of the mobile terminal, the wireless communication unit (110) comprising a broadcasting receiving module (111); **characterised in that**,
the broadcasting receiving module (111) is configured to receive a plurality of broadcast signals associated with multiple broadcasting technologies recognized at a location and scan channel frequencies for the plurality of broadcast signals associated with multiple broadcasting technologies; and the mobile terminal (100) further comprises:
a controller (180) configured to process a scan result received from the wireless communication unit (110), to obtain channel information for each broadcast signal from the scan result and to control the display of the obtained channel information; and
an output unit (150) configured to display the channel information for each broadcast signal under the control of the controller (180),
wherein the plurality of broadcast signals associated with multiple broadcasting technologies include valid region information, and
the mobile terminal is configured to recognize that it has changed regions and to receive broadcast signal information for valid broadcast signals in the new recognized location.

2. The mobile terminal (100) of claim 1, wherein the wireless communication unit (110) is configured to recognize a location of the mobile terminal (110) and the broadcasting receiving module (111) is configured to scan the channel frequencies for the broadcast signals available at the recognized location.

3. The mobile terminal (100) of claim 2, wherein the wireless communication unit (110) is configured to receive broadcast signal information related to the plurality of broadcast signals available at the recognized location and the broadcasting receiving module (111) is configured to scan the channel frequencies for the plurality of broadcast signals.

4. The mobile terminal (100) of claim 2, wherein the broadcasting receiving module (111) is configured to scan the channel frequencies for the plurality of broadcast signals and the controller (180) is configured to store the channel information for the plurality of broadcast signals in a memory (160).

5. The mobile terminal (100) of any of claims 1-4, wherein the controller (180) is configured to control the output unit (150) to display a recommended channel among the channels provided by the plurality of broadcast signals.

6. The mobile terminal (100) of any of claims 1-5, wherein the user input unit (130) is configured to receive a selection of a channel among the channels provided by the plurality of broadcast signals using the displayed channel information and the output unit (150) is configured to output a signal provided from the selected channel under control of the controller (180).

7. The mobile terminal (100) of claim 6, wherein the output unit (150) is configured to output a plurality of signals provided from a plurality of selected channels under control of the controller (180) if the user selects a plurality of channels provided by the plurality of broadcast signals.

8. The mobile terminal (100) of any of claims 6 and 7, wherein the output unit (150) is configured to output a new signal provided from a specific channel that is different from a currently selected channel if the user selects the specific channel among the channels provided by the broadcast signals.

9. The mobile terminal (100) of any of claims 6-8, wherein the controller (180) is configured to switch the selected channel to an alternative channel among the channels provided by the plurality of broadcast signals if a broadcast reception quality is less than a predetermined reference value and the output unit (150) is configured to output a new signal provided from the alternative channel.

10. The mobile terminal (100) of any of claims 1-9, wherein the user input unit (130) is configured to receive a selection from the plurality of broadcast signals, and the broadcasting receiving module (111) is configured to scan the channel frequencies for the selected plurality of broadcast signal under control of the controller (180).

11. The mobile terminal (100) of any of claims 1-10, wherein the wireless communication unit (110) is configured to receive broadcast relevant information and the output unit (150) is configured to display channel information matched to the received broadcast relevant information under control of the controller (180).

12. A method of supporting broadcast signals in a mobile terminal, **characterized by**:
recognizing (S605) a location of the mobile terminal;
receiving (S607) a plurality of broadcast signals associated with multiple broadcasting technologies recognized at a location;
scanning (S630) channel frequencies for the plurality of broadcast signals associated with multiple broadcasting technologies;
processing a scan result;
obtaining (S530) channel information for each broadcast signal from the scan result; and
displaying (S540) the obtained channel information for each broadcast signal,
wherein the plurality of broadcast signals associated with multiple broadcasting technologies include valid region information, and
when the mobile terminal recognizes that it has changed regions, the mobile terminal further receives broadcast signal information for valid broadcast signals in the new recognized location.

13. The method of claim 12, further comprising:
receiving broadcast relevant information; and
matching the received broadcast relevant information to the obtained channel information (S530),
wherein the displaying the obtained channel information comprises displaying the channel information matched to the broadcast relevant information (S540).

## Patentansprüche

1. Mobiles Endgerät (100) umfassend:
eine Benutzereingabeeinheit (130); und
eine drahtlose Kommunikationseinheit (110), die konfiguriert ist, einen Ort des mobilen Endgerät zu erkennen, wobei die drahtlose Kommunikationseinheit (110) ein Rundfunkempfängermodul (111) umfasst;
**gekennzeichnet dadurch, dass**
das Rundfunkempfänger Modul (111) konfiguriert ist, eine Vielzahl von Rundfunksignalen zu empfangen, die mit mehreren an einem Ort erkannten Rundfunktechnologien verknüpft sind, und Kanalfrequenzen für die Vielzahl von Rundfunksignalen, die mit mehreren Rundfunktechnologien verknüpft sind, zu prüfen; und das mobile Endgerät (100) ferner umfassend:
eine Steuereinheit (180), die konfiguriert ist, ein von der drahtlosen Kommunikationseinheit (110) empfangenes Prüfergebnis zu verarbeiten, um Kanalinformationen für jedes Rundfunksignal von dem Prüfergebnis zu erhalten und die Anzeige der erhaltenen Kanalinformationen zu steuern; und
eine Ausgabeeinheit (150), die konfiguriert ist, die Kanalinformationen für jedes Rundfunksignal unter Kontrolle der Steuereinheit (180) anzuzeigen,
wobei die Vielzahl von Rundfunksignalen, die mit mehreren Rundfunktechnologien verknüpft sind, gültige Bereichsinformationen enthalten, und
das mobile Endgerät konfiguriert ist, zu erkennen, dass es Bereiche gewechselt hat und Rundfunksignalinformationen für gültige Rundfunksignale an dem neuen erkannten Ort zu empfangen.

2. Mobiles Endgerät (100) nach Anspruch 1, wobei die drahtlose Kommunikationseinheit (110) konfiguriert ist, einen Ort des mobilen Endgerät (110) zu erkennen und das Rundfunkempfangsmodul (111) konfiguriert ist, die Kanalfrequenzen für die an dem erkannten Ort verfügbaren Rundfunksignale zu prüfen.

3. Mobiles Endgerät (100) nach Anspruch 2, wobei die drahtlose Kommunikationseinheit (110) konfiguriert ist, Rundfunksignalinformationen zu empfangen, die mit der Vielzahl von an dem erkannten Ort verfügbaren Rundfunksignalen verbunden sind und das Rundfunkempfangsmodul (111) konfiguriert ist, die Kanalfrequenzen für die Vielzahl von Rundfunksignalen zu prüfen.

4. Mobiles Endgerät (100) nach Anspruch 2, wobei das Rundfunkempfangsmodul (111) konfiguriert ist, die Kanalfrequenzen für die Vielzahl von Rundfunksignalen zu prüfen und die Steuereinheit (180) konfiguriert ist, die Kanalinformationen für die Vielzahl von Rundfunksignalen in einem Speicher (160) zu speichern.

5. Mobiles Endgerät (100) nach einem der Ansprüche 1 bis 4, wobei Steuereinheit auf 180) konfiguriert ist, die Ausgabeeinheit (150) zu steuern, um einen empfohlenen Kanal unter den durch die Vielzahl von Rundfunksignalen bereitgestellten Kanälen anzuzeigen.

6. Mobiles Endgerät (100) nach einem der Ansprüche 1 bis 5, wobei die Benutzereingabeeinheit (130) konfiguriert ist, eine Auswahl eines Kanals unter den durch die Vielzahl von Rundfunksignalen bereitgestellten Kanälen unter Verwendung der angezeigten Kanalinformationen zu empfangen und die Ausgabeeinheit (150) konfiguriert ist, ein von dem ausgewählten Kanal bereitgestelltes Signal unter Kontrolle der Steuereinheit (180) auszugeben.

7. Mobiles Endgerät (100) nach Anspruch 6, bei die Ausgabeeinheit (150) konfiguriert ist, eine Vielzahl von durch eine Vielzahl von ausgewählten Kanälen bereitgestellten Signalen unter Kontrolle der Steuereinheit (180) auszugeben, wenn der Nutzer eine Vielzahl von durch die Vielzahl von Rundfunksignalen bereitgestellten Kanälen auswählt.

8. Mobiles Endgerät (100) nach Anspruch 6 oder 7, wobei die Ausgabeeinheit (150) konfiguriert ist, ein neues Signal auszugeben, das von einem spezifischen Kanal, der sich von einem gerade ausgewählten Kanal unterscheidet, bereitgestellt wird, wenn der Nutzer den spezifischen Kanal unter den durch die Rundfunksignale bereitgestellten Kanälen auswählt.

9. Mobiles Endgerät (100) nach einem der Ansprüche 6 bis 8, wobei die Steuereinheit (180) konfiguriert ist, den ausgewählten Kanal zu einem alternativen Kanal unter den durch die Vielzahl von Rundfunksignalen bereitgestellten Kanälen zu schalten, wenn eine Rundfunkempfangsqualität kleiner als ein vorbestimmter Referenzwert ist und die Ausgabeeinheit (150) konfiguriert ist, ein neues von dem alternativen Kanal bereitgestelltes Signal auszugeben.

10. Mobiles Endgerät (100) nach einem der Ansprüche 1 bis 9, wobei die Benutzereingabeeinheit (130) konfiguriert ist, eine Auswahl von der Vielzahl von Rundfunksignalen zu empfangen, und das Rundfunkempfangsmodul (111) konfiguriert ist, die Kanalfrequenzen nach der ausgewählten Vielzahl von Rundfunksignalen unter Kontrolle der Steuereinheit (180) zu prüfen.

11. Mobiles Endgerät (100) nach einem der Ansprüche 1 bis 10, wobei die drahtlose Kommunikationseinheit (110) konfiguriert ist, rundfunkrelevante Informationen zu empfangen und die Ausgabeeinheit (150) konfiguriert ist, zu den empfangenen rundfunkrelevanten Informationen passende Kanalinformationen unter Kontrolle der Steuereinheit (180) anzuzeigen.

12. Verfahren zum Unterstützen von Rundfunksignalen in einem mobilen Endgerät, **gekennzeichnet durch**:
Erkennen (S605) eines Orts des mobilen Endgeräts;
Empfangen (S607) einer Vielzahl von Rundfunksignalen, die mit mehreren an einem Ort erkannten Rundfunktechnologien verknüpft sind;
Prüfen (S630) von Kanalfrequenzen für die Vielzahl von mit mehreren Rundfunktechnologien verknüpften Rundfunksignalen;
Verarbeiten eines Prüfergebnisses;
Erhalten (S530) von Kanalinformationen für jedes Rundfunksignal von dem Prüfergebnis; und
Anzeigen (S540) der erhaltenen Kanalinformationen für jedes Rundfunksignal,
wobei die Vielzahl von mit mehreren Rundfunktechnologien verknüpften Rundfunksignalen gültige Bereichsinformationen enthält, und
wenn das mobile Endgerät erkennt, dass es Bereiche gewechselt hat, das mobile Endgerät ferner Rundfunksignalinformationen für gültige Rundfunksignale an dem neu erkannten Ort empfängt.

13. Verfahren nach Anspruch 12, ferner umfassend:
Empfangen von rundfunkrelevanten Informationen; und
Anpassen der empfangenen rundfunkrelevanten Informationen an die erhaltenen Kanalinformationen (S530),
wobei das Anzeigen der erhaltenen Kanalinformationen Anzeigen der zu den rundfunkrelevanten Informationen passenden Kanalinformationen (S540) umfasst.

## Revendications

1. Terminal mobile (100) comprenant :
une unité d'entrée utilisateur (130) ; et
une unité de communication sans fil (110) configurée pour reconnaître une localisation du terminal mobile, l'unité de communication sans fil (110) comprenant un module de réception de radiodiffusion (111) ;
**caractérisé en ce que**,
le module de réception de radiodiffusion (111) est configuré pour recevoir une pluralité de signaux de radiodiffusion associés à de multiples technologies de radiodiffusion reconnus à une localisation et des fréquences de canaux de balayage pour la pluralité de signaux de radiodiffusion associés à de multiples technologies de radiodiffusion ;
et le terminal mobile (100) comprend en outre :
un contrôleur (180) configuré pour traiter un résultat de balayage reçu de l'unité de communication sans fil (110), pour obtenir des informations de canaux pour chaque signal de radiodiffusion à partir du résultat de balayage et pour commander l'affichage des informations de canaux obtenues ; et
une unité de sortie (150) configurée pour afficher les informations de canaux pour chaque signal de radiodiffusion sous la commande du contrôleur (180),
dans lequel la pluralité des signaux de radiodiffusion associés à de multiples technologies de radiodiffusion comprennent des informations de région valide, et
le terminal mobile est configuré pour reconnaître qu'il a changé de région, et pour recevoir des informations de signaux de radiodiffusion pour des signaux de radiodiffusion valides dans la nouvelle localisation reconnue.

2. Terminal mobile (100) selon la revendication 1, dans lequel l'unité de communication sans fil (110) est configurée pour reconnaître une localisation du terminal mobile (110) et le module de réception de radiodiffusion (111) est configuré pour balayer les fréquences de canaux pour les signaux de radiodiffusion disponibles à la localisation reconnue.

3. Terminal mobile (100) selon la revendication 2, dans lequel l'unité de communication sans fil (110) est configurée pour recevoir des informations de signaux de radiodiffusion se rapportant à la pluralité de signaux de radiodiffusion disponibles à la localisation reconnue et le module de réception de radiodiffusion (111) est configuré pour balayer les fréquences de canaux pour la pluralité de signaux de radiodiffusion.

4. Terminal mobile (100) selon la revendication 2, dans lequel le module de réception de radiodiffusion (111) est configuré pour balayer les fréquences de canaux pour la pluralité de signaux de radiodiffusion et le contrôleur (180) est configuré pour mémoriser les informations de canaux pour la pluralité de signaux de radiodiffusion dans une mémoire (160).

5. Terminal mobile (100) selon l'une quelconque des revendications 1 à 4, dans lequel le contrôleur (180) est configuré pour commander l'unité de sortie (150) pour afficher un canal recommandé parmi les canaux fournis par la pluralité de signaux de radiodiffusion.

6. Terminal mobile (100) selon l'une quelconque des revendications 1 à 5, dans lequel l'unité d'entrée utilisateur (130) est configurée pour recevoir une sélection d'un canal parmi les canaux fournis par la pluralité de signaux de radiodiffusion en utilisant les informations de canaux affichées et l'unité de sortie (150) est configurée pour délivrer en sortie un signal délivré depuis le canal sélectionné sous la commande du contrôleur (180).

7. Terminal mobile (100) selon la revendication 6, dans lequel l'unité de sortie (150) est configurée pour délivrer en sortie une pluralité de signaux délivrés depuis une pluralité de canaux sélectionnés sous la commande du contrôleur (180) si l'utilisateur sélectionne une pluralité de canaux fournis par la pluralité de signaux de radiodiffusion.

8. Terminal mobile (100) selon l'une quelconque des revendications 6 et 7, dans lequel l'unité de sortie (150) est configurée pour délivrer en sortie un nouveau signal délivré depuis un canal spécifique qui est différent d'un canal actuellement sélectionné si l'utilisateur sélectionne le canal spécifique parmi les canaux fournis par les signaux de radiodiffusion.

9. Terminal mobile (100) selon l'une quelconque des revendications 6 à 8, dans lequel le contrôleur (180) est configuré pour commuter le canal sélectionné vers un canal alternatif parmi les canaux fournis par la pluralité de signaux de radiodiffusion si une qualité de réception de radiodiffusion est inférieure à une valeur de référence prédéterminée et l'unité de sortie (150) est configurée pour délivrer en sortie un nouveau signal délivré depuis le canal alternatif.

10. Terminal mobile (100) selon l'une quelconque des revendications 1 à 9, dans lequel l'unité d'entrée utilisateur (130) est configurée pour recevoir une sélection à partir de la pluralité de signaux de radiodiffusion, et le module de réception de radiodiffusion (111) est configuré pour balayer les fréquences de canaux pour la pluralité de canaux de radiodiffusion sélectionnés sous la commande du contrôleur (180).

11. Terminal mobile (100) selon l'une quelconque des revendications 1 à 10, dans lequel l'unité de communication sans fil (110) est configurée pour recevoir des informations pertinentes de radiodiffusion et l'unité de sortie (150) est configurée pour afficher les informations de canaux en correspondance avec les informations pertinentes de radiodiffusion reçues sous la commande du contrôleur (180).

12. Procédé de support de signaux de radiodiffusion dans un terminal mobile, **caractérisé par** les étapes consistant à :
reconnaître (S605) une localisation du terminal mobile ;
recevoir (S607) une pluralité de signaux de radiodiffusion associés à de multiples technologies de radiodiffusion reconnus à une localisation ;
balayer (S630) des fréquences de canaux pour la pluralité de signaux de radiodiffusion associés à de multiples technologies de radiodiffusion ;
traiter un résultat de balayage ;
obtenir (S530) des informations de canaux pour chaque signal de radiodiffusion à partir du résultat de balayage ; et
afficher (S540) les informations de canaux obtenues pour chaque signal de radiodiffusion,
dans lequel la pluralité des signaux de radiodiffusion associés à de multiples technologies de radiodiffusion comprennent des informations de région valide, et
lorsque le terminal mobile reconnaît qu'il a changé de région, le terminal mobile reçoit en outre des informations de signaux de radiodiffusion pour des signaux de radiodiffusion valides dans la nouvelle localisation reconnue.

13. Procédé selon la revendication 12, comprenant en outre les étapes consistant à :
recevoir des informations pertinentes de radiodiffusion ; et
mettre en correspondance les informations pertinentes de radiodiffusion reçues avec les informations de canaux obtenues (S530),
dans lequel l'affichage des informations de canaux obtenues comprend l'affichage des informations de canaux mises en correspondance avec les informations pertinentes de radiodiffusion (S540).
